Europäisches Patentamt

European Patent Office

Office européen des brevets

(11) Publication number: **0 214 512**
**A2**

## EUROPEAN PATENT APPLICATION

(21) Application number: **86111457.7**

(51) Int. Cl.4: **H01L 21/76** , H01L 21/20

(22) Date of filing: **19.08.86**

(30) Priority: **05.09.85 US 772782**

(43) Date of publication of application:
**18.03.87 Bulletin 87/12**

(84) Designated Contracting States:
**BE DE FR GB NL**

(71) Applicant: **EASTMAN KODAK COMPANY**
**Patent Department 343 State Street**
**Rochester New York 14650(US)**

(72) Inventor: **Lubberts, Gerrit**
**17 Holley Brook Drive**
**Penfield New York 14526(US)**

(74) Representative: **Parent, Yves et al**
**Kodak-Pathé Département Brevets et**
**Licences Centre de Recherches et de**
**Technologie Zone Industrielle**
**F-71102 Chalon-sur-Saone Cédex(FR)**

(54) **Expitaxially grown isolation device.**

(57) There is disclosed a device and method of making such, for isolating active elements of an integrated circuit on a substrate. The device comprises a trench filling of epitaxially grown semiconductor material fused with the substrate at the bottom of the filling. The fused semiconductor material is laterally spaced away from the substrate, the lateral space between the trench filling and the substrate on both sides of the filling comprising i) a layer of an oxide of the substrate; and ii) a layer of a first material effective to protect the materials under the first material layer from attack during the formation of the filling of epitaxially grown material.

FIG 5

EP 0 214 512 A2

# EXPITAXIALLY GROWN ISOLATION DEVICE

This invention relates to integrated circuits and methods of making the same, and particularly to techniques used to isolate active elements of the circuit.

Isolation devices are well known in the art of making integrated circuits, as a means of isolating two or more active elements on the same semiconductor substrate. Such devices are a necessary feature as more and more active elements are crowded onto the limited real estate of the semiconductor substrate.

A conventional method of isolation has been to grow silicon dioxide on exposed silicon areas, with or without a trench, to produce a recessed oxide isolation area. The problem with such a conventional approach, as explained, for example, in Figs. 1-7B of U.S. Patent No. 4,272,308, has been that the growing oxide penetrates under a silicon nitride layer added for protection, thus pushing the latter up at its edges to create an undesired, but well-known, "bird's beak" phenomenon. Such undesired structure is unusable for active elements, and thus decreases the amount of useful area in an integrated circuit. Since more and more active elements are needed on the same-sized, or even smaller wafers, anything that decreases the amount of useful area must be avoided.

Two approaches have been suggested to avoid this problem. One corresponds to the solution presented in U.S. Patent No. 4,272,308 noted above, and the other corresponds to that set forth in "Deep Trench Isolated CMOS Devices", Rung et al, IEDM 82, pp. 237 and 239 (1982). In both cases, an isolating trench is formed, using 3 or 4 steps: In '308, the steps are to form a first layer of oxide on the surface, deposit a flat layer of $Si_3N_4$ on the oxide layer, and etch out only the $Si_3N_4$ layer and the oxide layer to form a shallow trench. In IEDM, the first two steps are the same. An additional step of adding a protective third layer of $SiO_2$ is added before the trench formation, because the trench in this case goes deep into the substrate as well.

Thereafter, the sidewalls of the trench are protected. In the case of the procedure of the '308 patent, it is by adding $Si_3N_4$ to the shallow trench and to the remaining $Si_3N_4$. In the case of the IEDM procedure, it is by oxidizing the sidewalls of the trench. At this point, the IEDM trench is ready for filling, but the shallow trench of the '308 patent requires an etching to remove the $Si_3N_4$ from the trench bottom.

The trench filling steps are different. In the '308 patent, $SiO_2$ is grown within most of the shallow trench, the extra $Si_3N_4$ layer on the trench being alleged to prevent "bird's beak." In the IEDM procedure, either $SiO_2$ or polysilicon is deposited within the trench to fill it. In the latter case, the silicon cannot be epitaxial silicon, because the remaining oxide layer at the bottom of the trench prevents such from occurring.

Both prior procedures have disadvantages. Filling even a shallow trench with $SiO_2$ is disadvantageous because the volume the $SiO_2$ tries to occupy is greater than the empty space of the trench. If a "bird's beak" is not created as alleged, then it is at the expense of providing considerable stress on the surface layers of the device. It is true, of course, that the IEDM procedure suggests, instead, the use of polysilicon, but such polysilicon is not grounded to the remaining portions of the device since it is isolated by an oxide layer. Thus, it can develop or transmit a charge that adversely affects an adjacent active device. Furthermore, it is sometimes difficult to uniformly fill a relatively deep trench with polysilicon.

In view of the above, the technical problem addressed by the instant invention is to provide an isolation device between active elements of an integrated circuit that does not suffer from the serious disadvantages noted above. This problem is solved by providing an isolation device between active elements of a circuit constructed on a single crystal substrate. The device comprises a trench filling of epitaxially grown semiconductor material fused with the substrate at the bottom of the filling, the fused semiconductor material being laterally spaced away from the substrate, the lateral space between the trench filling and the substrate on both sides of the filling comprising i) a layer of an oxide of the substrate, and ii) a layer of a first material effective to protect the materials under the first material layer from attack during the formation of the epitaxially grown filling.

In accord with another aspect of the invention, the solution of the problem also involves a process for making such a device. The process comprises the steps of a) etching a trench in the substrate, b) forming an oxide on the substrate along the sidewalls of the trench, c) depositing overall a layer of a first material effective to protect the materials under the first material layer from attack during the formation of the filling of epitaxially grown material, d) etching out the layers of the first material, and second material, if any, at the bottom of the trench, and e) epitaxially growing semiconductor material in the trench, fused to the substrate at the bottom of the trench.

Thus the invention advantageously features an isolation device and a method of producing it wherein the doped Si in the trench is grounded to the substrate due to its epitaxial nature.

It is a further advantageous feature of the invention that such a device is free of the "bird's beak" phenonenon, thus increasing the useful area of the substrate for active elements.

Yet another advantageous feature of the invention, compared to local field oxidation isolation techniques, is that a more planar structure is produced, using a uniform trench-filling material.

The present invention will now be described by way of example with reference to the attached drawings in which:

Figs. 1-5 are fragmentary sectional views illustrating the process for making the isolation device of the invention, and

Fig. 6 is a fragmentary sectional view similar to that of Fig. 5, except that an alternative embodiment is illustrated.

The subject invention is described in connection with a preferred embodiment wherein the substrate of the IC is silicon, layers formed thereon are silicon dioxide and $Si_3N_4$, and the epitaxially grown material is silicon. In addition, the invention is applicable to an isolation device and process prepared using some other semiconductor material, and layers thereupon of other materials having the intended function that is set forth for such layers.

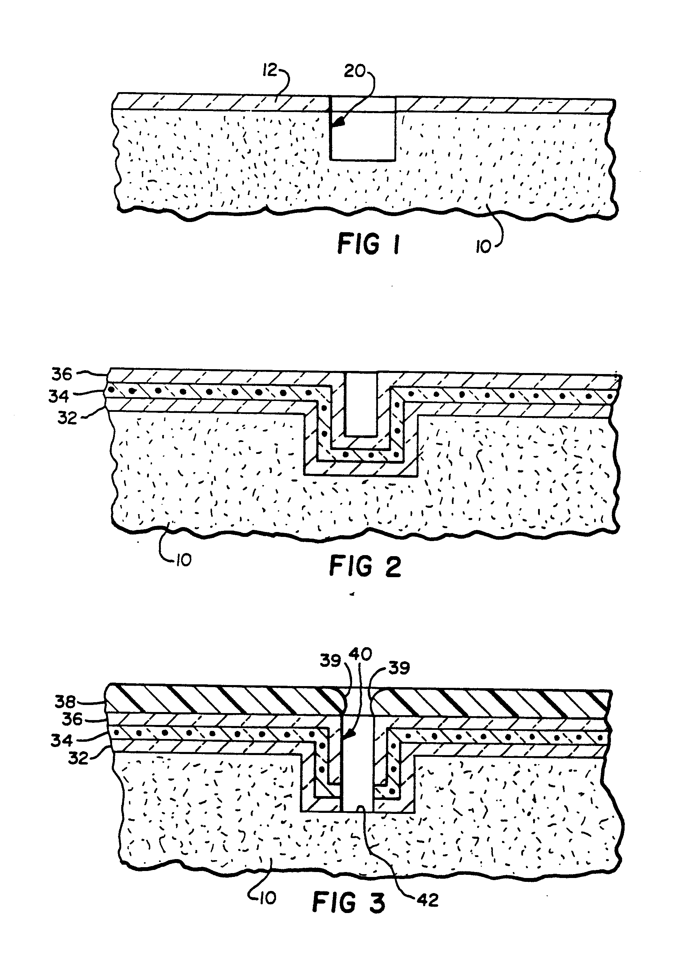

In accord with the invention, the isolation device is prepared, Fig. 1, by etching out a trench 20 in a substrate 10 of single crystalline silicon that is to form the IC. A preferred method of carrying out such an etch treatment is to first grow a thermal oxide layer 12, up to about 1000Å, for example, and then expose and develop a suitable photoresist that leaves open to attack the area in which a temporary trench 20 is to be formed. An anisotropic etch is preferred, for example, by using reactive ion etching, for example, using $CF_4$ plasma. The depth of the temporary trench 20 will vary, depending mostly on the doping levels within the trench. For doping that is about $10^{18}/cm3$ in the trench, the depth of the trench should be at least about 2 μm. The length of the trench is dictated by the shape of the active area to be isolated. The width is about, e.g., 2 μm.

Thereafter, Fig. 2, a layer 32 of thermal oxide is formed overall by heating the substrate. This layer of course merges with previous layer 12, or layer 12 can be removed before layer 32 is grown. Preferably such layer is selected such that the thickness on the sidewalls of the trench is between about 500 and about 700Å thick. A layer 34 of a first material is formed on layer 32 in a conventional manner, followed by a layer 36 of a second material. The compositions of the first and second materials are not critical, except that they are selected to provide the following functions: The first material is to protect the materials underneath from attack when the trench is filled by growing epitaxial silicon of the same conductivity type as substrate 10. One conventional process for epitaxial growth involves the use of $H_2$, HCl and $SiH_4$ gas. It is this gas that can otherwise attack, e.g., layer 32 in the absence of layer 34. One preferred material that resists such attack is $Si_3N_4$, at a preferred thickness of from about 500Å to about 1000Å.

The second material (layer 36) is to retard nucleation of the Si on layer 34 during the epitaxial growth process. A suitable material for this process is low temperature $SiO_2$, which preferably is formed by low pressure chemical vapor deposition, about 1000Å to about 1500Å thick.

Thereafter, Fig. 3, a layer 38 of a suitable photoresist is flowed onto the result of Fig. 2, such as by spin coating. After coating, the resist is exposed and developed to leave an aperture over the trench. To align sidewalls 39 with the trench, the resist can be heated to cause it to flow outwardly to the position shown. An example of such a photoresist is Kodak Micro Resist 747. Edges 39 of the resist leave exposed to etching just the bottom of trench 40. More specifically, an anisotropic etch step is next used, such as directional reactive sputter etching, for example using $CF_4$ and $H_2$ plasma to remove all three layers 36, 34 and 32, but only at the bottom of trench 40. This step exposes substrate 10 at surface 42.

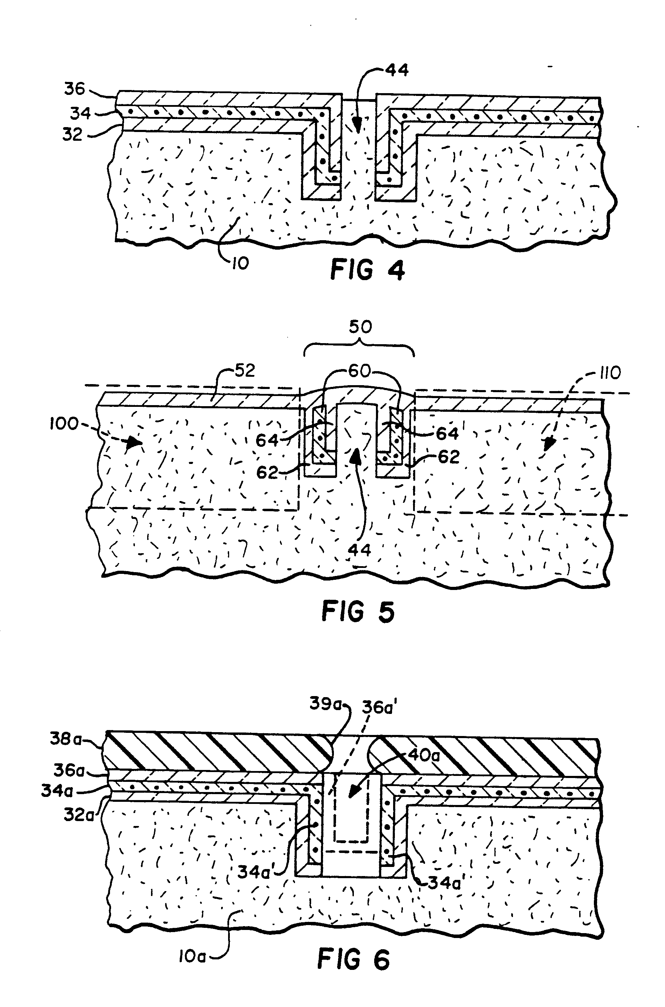

Next, Fig. 4, the photoresist is removed and trench 40 is filled by epitaxially growing p + or n + doped silicon, as appropriate, within the trench commencing at surface 42, until filling 44 is completed. Any epitaxial growth technique is useful, for example one in which the gas is $SiH_4/HCl/H_2$ at 1150°C. Layer 36, e.g., of the low-temperature oxide is effective in resisting nucleation of polysilicon outside the trench. Layer 34, e.g., of $Si_3N_4$, keeps the HCl of the silicon growth process from attacking the substrate 10. The epitaxial growth tends to be more uniform in its filling, than is polysilicon.

At this point, all of layers 36, 34 and 32, except those strips now buried as part of isolation area 50, are etched off the substrate using conventional etchants. A new layer 52 of thermal $SiO_2$ is grown which merges with the buried portions of the previous oxide layers, leaving segments 60 of $Si_3N_4$ on both sides of filling 44 that are L-shaped when viewed in the transverse cross-section provided by Fig. 5. The $Si_3N_4$ segments 60, as well as the $SiO_2$

strips 62, 64 adjacent segments 60 on both sides thereof, act to create an isolation between filling 44 and the portions of substrate 10 immediately adjacent isolation area 50. It is such adjacent substrate portions that are thereafter processed into active elements 100 and 110, delineated by dashed lines, of the IC. Both the process and the resulting active elements are conventional and require no further description.

Alternatively, Fig. 6, etching prior to epitaxial growth can be modified so as to remove the $SiO_2$ layer from the sidewalls of the $Si_3N_4$ layer. Parts similar to those previously described bear the same reference numerals to which the distinguishing suffix "a" has been appended. Thus, layers 32a, 34a, 36a and 38a are deposited onto the substrate 10a as before. However, a wet isotropic etch is used to remove all of the $SiO_2$ portions 36a' within the trench shown by a dotted line. Thereafter, an anisotropic etch is used to produce the result shown in Fig. 6. Trench 40a then is completely filled, resulting in the epitaxial Si being contiguous with the sidewall portions 34a' of the $Si_3N_4$ segment.

Yet another alternative method of eliminating the interior sidewall of $SiO_2$ from the trench is to skip the deposition of layer 36 or 36a entirely. When Si is subsequently deposited to form the epitaxial fill in the trench, there may be islands of polysilicon also deposited onto the layer of $Si_3N_4$ on the surface, outside of the trench. Such islands are optionally removed by stopping the Si deposition step periodically, and using an appropriate etch treatment.

The previously-described embodiments feature both an n-type substrate and an n-type trench filling as a preferred embodiment. In addition, the invention is applicable to a p-type substrate (using a p-type trench filling).

**Claims**

1. In an integrated circuit constructed on a single crystal substrate, an isolation device between active elements of the circuit and within said substrate, the device comprising

a trench filling of epitaxially grown semiconductor material fused with said substrate at the bottom of said filling, said fused semiconductor material being laterally spaced away from said substrate,

and in the lateral space between said trench filling and said substrate, on both sides of said filling,

    i) a layer of an oxide of said substrate; and

    ii) a layer of a first material effective to protect the materials under said first material layer from attack during the formation of said epitaxially grown filling.

2. An isolation device as described in claim 1, and further including, between said trench filling and said layer of first material, a layer of a second material effective to retard nucleation of said semiconductor material on said layer of first material.

3. An isolation device as described in claim 2, wherein said substrate and said grown semiconductor material is silicon, said first material is $Si_3N_4$, and said second material is low temperature silicon oxide.

4. A device as described in claim 3, wherein said $Si_3N_4$ is confined to segments having an L-shape when viewed in transverse cross-section.

5. A process for making an isolation device in an integrated circuit between active elements of the circuit and within a single crystal substrate of said circuit, the process comprising the steps of

    a) etching a trench in said substrate,

    b) forming an oxide on said substrate along the sidewalls of said trench,

    c) depositing overall a layer of a first material effective to protect the materials under said first material layer from attack during the formation of said filling of epitaxially grown material,

    d) etching out said layers of first material, and second material, if any, at the bottom of said trench, and

    e) epitaxially growing semiconductor material in said trench, fused to said substrate at the bottom of said trench.

6. A process as defined in claim 5, and further including, between said steps c) and d) the step of depositing overall a layer of a second material effective to retard nucleation of semiconductor material onto said layer of first material when epitaxial semiconductor material is deposited in said trench.

7. A process as defined in claim 5, wherein said substrate and said grown semiconductor material is silicon, said first material is $Si_3N_4$, and said second material is low temperature silicon oxide.

8. A process as defined in claim 7, wherein said $Si_3N_4$ is confined to segments having an L-shape when viewed in transverse cross-section.

FIG 1

FIG 2

FIG 3

FIG 4

FIG 5

FIG 6